(19) Europäisches Patentamt
European Patent Office
Office européen des brevets

(11) EP 3 543 294 A1

(12) # EUROPEAN PATENT APPLICATION

published in accordance with Art. 153(4) EPC

(43) Date of publication:
**25.09.2019 Bulletin 2019/39**

(21) Application number: **17870952.3**

(22) Date of filing: **16.11.2017**

(51) Int Cl.:
***C08L 101/00*** *(2006.01)*
***B29C 33/38*** *(2006.01)*
***B29C 59/02*** *(2006.01)*
***C08K 3/00*** *(2018.01)*
***C08K 5/04*** *(2006.01)*
***C08K 5/16*** *(2006.01)*
***C08L 23/00*** *(2006.01)*
***C08L 83/04*** *(2006.01)*
***H01L 21/027*** *(2006.01)*

(86) International application number:
**PCT/JP2017/041288**

(87) International publication number:
**WO 2018/092848 (24.05.2018 Gazette 2018/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **18.11.2016 JP 2016225226**

(71) Applicant: **Daicel Corporation**
**Osaka-shi, Osaka 530-0011 (JP)**

(72) Inventors:
- **MIYAKE, Hiroto**
  **Himeji-shi**
  **Hyogo 671-1283 (JP)**
- **TSUTSUMI, Kiyoharu**
  **Tokyo 108-8230 (JP)**

(74) Representative: **Grünecker Patent- und Rechtsanwälte**
**PartG mbB**
**Leopoldstraße 4**
**80802 München (DE)**

(54) **RESIN COMPOSITION FOR FORMING REPLICA MOLD, REPLICA MOLD AND PATTERN FORMING METHOD USING SAID REPLICA MOLD**

(57) Provided is a resin composition capable of forming an imprint replica mold that enables easy removal of a residual layer and enables formation of high-accuracy patterns. The resin composition for replica mold formation includes (A) a thermoplastic or thermosetting resin, and (B) a compound. The resin (A) has a transmittance of light of 50% or more at one or more wavelengths from 200 to 450 nm. The compound (B) is capable of absorbing or scattering light at the wavelength(s). The compound (B) is present in a proportion of 0.5 to 50 parts by weight per 100 parts by weight of the resin (A). The resin (A) is preferably selected from olefinic resins and silicone resins.



Printed by Jouve, 75001 PARIS (FR)

## Description

Technical Field

The present invention relates to: resin compositions for replica mold formation; replica molds including a cured product or solidified product of the resin compositions for replica mold formation; and patterning methods using the replica molds. This application claims priority to Japanese Patent Application No. 2016-225226, filed November 18, 2016 to Japan, the entire contents of which are incorporated herein by reference.

Background Art

In a production process typically of semiconductor devices, fine patterns (fine traces) are generally formed by photolithography. Disadvantageously, however, this technique typically requires expensive equipment such as aligners and is performed with a large number of steps and complicated operations.

A possible solution to these disadvantages is the use of imprinting technique (imprint lithography) instead of the photolithography. With the imprinting technique, a mold having a patterned relief structure is brought into contact with and pressed against a resin layer disposed on a substrate, to transfer or replicate the pattern to the resin layer, and the patterned resin layer is then cured or solidified to form into a resin layer having a relief pattern. This technique enables formation of fine patterns with a simple operation and contributes to cost reduction. According to this technique, however, when the mold is brought into contact with and pressed against the resin layer, a gap is inevitably formed between the substrate and the protrusions of the mold, and a thin resin layer (hereinafter also referred to as a "residual layer") remains in the gap. The residual layer has to be removed, but is very hardly removed thoroughly. This causes one to hesitate to employ the imprinting technique.

With the technique disclosed in Patent Literature (PTL) 1, a chromium film having light-shielding ability is formed on a quartz substrate, etched, and yields a mold (master mold) having a patterned relief structure, in which the chromium film having light-shielding ability is present on protrusions. While the master mold is brought into contact with and pressed against a photocurable resin layer disposed on a substrate, the photocurable resin layer is irradiated with ultraviolet radiation. Thus, a pattern is formed while the chromium film impeding the ultraviolet radiation from passing therethrough to a residual layer portion, and the uncured residual layer can be easily removed by washing with an organic solvent. Disadvantageously, however, this technique suffers from high cost, because the master mold is very expensive and is not reusable since the chromium film disposed on the protrusions tends to be separated (flaked).

Citation List

Patent Literature

PTL 1: Japanese Unexamined Patent Application Publication (JP-A) No. 2004-304097

Summary of Invention

Technical Problem

Accordingly, the present invention has an object to provide a resin composition capable of forming an imprint replica mold that enables easy removal of a residual layer and can form high-accuracy patterns.

The present invention has another object to provide an imprint replica mold that enables easy removal of a residual layer and can form high-accuracy patterns.

The present invention has yet another object to provide a patterning method using the imprint replica mold, where the method enables easy removal of a residual layer and can form high-accuracy patterns.

Solution to Problem

After intensive investigations to achieve the objects, the inventors of the present invention found a composition containing a transparent resin combined with a component capable of absorbing or scattering light at one or more wavelengths from 200 to 450 nm. The inventors also found as follows. When a mold having a patterned relief structure is formed using the composition, protrusions and a base portion of the mold have a difference from each other in thickness and can thereby have a difference in transmittance of light at the wavelength(s). This configuration allows the protrusions to have a lower transmittance of light at the wavelength(s) as compared with the base portion. Accordingly, when the pattern of the mold is imprinted (replicated) to a coated film of a photocurable composition, and light at one or more

wavelengths from 200 to 450 nm is applied through the mold to the coated film to cure the photocurable composition, a pattern can be formed while impeding curing of a residual layer, and the resulting residual layer can be easily removed by washing (cleaning). The present invention has been made on the basis of these findings.

Specifically, the present invention provides, in one aspect, a resin composition for replica mold formation, which contains (A) a thermoplastic or thermosetting resin and (B) a compound. The resin (A) has a transmittance of light of 50% or more at one or more wavelengths from 200 to 450 nm. The compound (B) is capable of absorbing or scattering the light at the wavelength(s). The compound (B) is present in a proportion of 0.5 to 50 parts by weight per 100 parts by weight of the resin (A).

In the resin composition for replica mold formation, the resin (A) may be selected from olefinic resins and silicone resins.

The present invention also provides, in another aspect, a replica mold including a cured product or solidified product of the resin composition for replica mold formation.

The present invention also provides, in yet another aspect, a patterning method. The method includes pressing the replica mold against a coated film including a photocurable composition, curing the coated film, removing the replica mold, and removing a residual layer by washing. Advantageous Effects of Invention

Imprinting using a replica mold formed using the resin composition for replica mold formation according to the present invention enables easy removal of a residual layer typically by washing and can produce high-accuracy patterns simply and inexpensively. The replica mold enables formation of patterns by roll-to-roll process and contributes to dramatically higher working efficiency.

## Brief Description of Drawing

FIG. 1, the sole figure, schematically illustrates a patterning method according to an embodiment of the present invention.

## Description of Embodiments

### Resin Composition for Replica Mold Formation

The resin composition for replica mold formation according to the present invention contains a thermoplastic or thermosetting resin (A) and a compound (B). The resin (A) has a transmittance of light of 50% or more at one or more wavelengths from 200 to 450 nm. The compound (B) is capable of absorbing or scattering the light at the wavelength(s). The compound (B) is present in a proportion of 0.5 to 50 parts by weight per 100 parts by weight of the resin (A).

### Resin (A)

The resin (A) for use in the present invention is a thermoplastic resin or thermosetting resin having a transmittance of light of 50% or more (preferably 80% or more, and particularly preferably 90% or more) at one or more wavelengths from 200 to 450 nm. The resin composition according to the present invention contains the resin (A) having a transmittance of light of 50% or more at the wavelength(s) and is thereby advantageously usable for the formation of a replica mold for imprinting to a photocurable composition. Disadvantageously, a resin having a transmittance of light of less than the range at the wavelength(s), if used for the use, fails to allow the photocurable composition to be sufficiently cured.

The transmittance of light at the wavelength(s) in the resin (A) can be determined by applying light at one or more wavelengths from 200 to 450 nm to a test specimen, and measuring the transmittance of the light using a spectrophotometer, where, when the resin (A) is a thermosetting resin, the test specimen is a cured product (2-mm thick) of the resin (A), and, when the resin (A) is a thermoplastic resin, the test specimen is a solidified product (2-mm thick) of the resin (A).

Non-limiting examples of the resin (A) include acrylic resins, styrenic resins, olefinic resins, acrylic urethane resins, and silicone resins.

Among them, the resin (A) for use in the present invention is preferably selected from olefinic resins and silicone resins, because these resins excel in transmittance of light at one or more wavelengths from 200 to 450 nm.

#### Olefinic Resins

The olefinic resins are polymers or copolymers each derived from one or more olefinic monomers having a carbon-carbon double bond. The olefinic monomers include chain olefins and cyclic olefins. The copolymers include block copolymers, graft copolymers, and random copolymers.

Non-limiting examples of the chain olefins (i.e., chain hydrocarbons having a carbon-carbon double bond)

include $C_2$-$C_{30}$ linear or branched $\alpha$-olefins such as ethylene, propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-hexene, 4,4-dimethyl-1-pentene, 4-ethyl-1-hexene, 3-ethyl-1-hexene, 1-octene, 1-decene, 1-dodecene, 1-tetradecene, 1-hexadecene, 1-octadecene, and 1-eicosene; and $C_3$-$C_{30}$ linear or branched polyenes such as 1,3-butadiene.

Non-limiting examples of the cyclic olefins (i.e., alicyclic hydrocarbons having a carbon-carbon double bond in the ring) include monocyclic hydrocarbons having a carbon-carbon double bond in the ring, such as cyclobutene, cyclopentene, cyclopentadiene, cyclooctene, and cyclododecene, of which cycloalkenes (including cycloalkadienes) are typified; and polycyclic hydrocarbons having a carbon-carbon double bond in the ring, including bicyclic hydrocarbons such as norbornene, norbornadiene, and bicyclo[3.2.1]oct-2-ene, tricyclic hydrocarbons such as dicyclopentadiene, 5,6-dihydrodicyclopentadiene, and acenaphthylene, and tetracyclic hydrocarbons such as tetracyclododecene, of which bridged hydrocarbons (including bridged dienes) are typified.

The cyclic olefins may each have one or more substituents. Non-limiting examples of the substituents include halogens, oxo, hydroxy, substituted oxys (such as $C_1$-$C_4$ alkoxys, $C_6$-$C_{10}$ aryloxys, $C_7$-$C_{16}$ aralkyloxys, and $C_1$-$C_4$ acyloxys), carboxy, substituted oxycarbonyls (such as $C_1$-$C_4$ alkoxycarbonyls, $C_6$-$C_{10}$ aryloxycarbonyls, and $C_7$-$C_{16}$ aralkyloxycarbonyls), substituted or unsubstituted carbamoyls, cyano, nitro, substituted or unsubstituted aminos, sulfo, heterocyclic groups, alkyls (exemplified by $C_1$-$C_4$ alkyls such as methyl and ethyl), alkenyls (exemplified by $C_2$-$C_4$ alkenyls such as vinyl, allyl, and 1-butenyl), alkynyls (exemplified by $C_2$-$C_4$ alkynyls such as ethynyl and propynyl), $C_3$-$C_8$ cycloalkyls, and aryls (exemplified by $C_6$-$C_{10}$ aryls such as phenyl and naphthyl).

Of the olefinic resins, preferred are copolymers between a cyclic olefin (in particular, norbornene) and a chain olefin (in particular, ethylene).

The olefinic resins each have a glass transition temperature of typically 50°C to 300°C. Of the glass transition temperature, the lower limit is preferably 70°C; and the upper limit is preferably 200°C, particularly preferably 150°C, and most preferably 130°C, for excellent conformability to finer (more minute) relief structures. When such an olefinic resin is a copolymer between a cyclic olefin and a chain olefin, the glass transition temperature of the olefinic resin can be adjusted by controlling the proportion of structural units derived from the cyclic olefin. The olefinic resin tends to have a higher glass transition temperature when including a larger proportion of structural units derived from the cyclic olefin.

The olefinic resins for use herein are advantageously available as commercial products typically under the trade names of: TOPAS® (from Polyplastics Co., Ltd.); APEL® (from Mitsui Chemicals Inc.); ZEONEX® (from ZEON CORPORATION); ZEONOR® (from ZEON CORPORATION); and ARTON® (from JSR Corporation).

Silicone Resins

The silicone resins are polymers each having a main skeleton including siloxane bonding and are represented typically by Formula (a):

[Chem. 1]

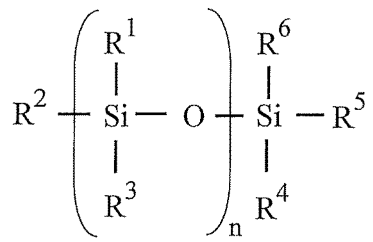

(a)

wherein $R^1$ to $R^6$ are each, identically or differently in each occurrence, selected from hydrogen and an optionally substituted hydrocarbon group; and n represents an integer of 1 or more. When n is an integer of 2 or more, two or more occurrences of $R^1$ may be identical or different, and two or more occurrences of $R^3$ may be identical or different.

The hydrocarbon group is preferably selected from $C_1$-$C_{10}$ alkyls such as methyl; and $C_6$-$C_{10}$ aryls such as phenyl. Non-limiting examples of substituents which the hydrocarbon group may have include amino, epoxy, cycloaliphatic epoxys (such as cyclohexene oxide group), hydroxy, carboxy, mercapto, (meth)acryloyl, polyether groups, and halogens.

The silicone resins for use herein are advantageously available as commercial products typically under the trade names of: X-32-1232 and KER-4690-A/B (polydimethylsiloxane) (each from Shin-Etsu Chemical Co., Ltd.); and SYLGARD 184 (from Dow Corning Toray Co., Ltd.).

Assume that the resin composition contains, as the resin (A), a silicone resin (in particular, a compound represented by Formula (a) and substituted with at least one substituent selected from amino, epoxy (i.e., oxiranyl), cycloaliphatic epoxys (such as a cyclohexene oxide group), hydroxy, carboxy, mercapto, and (meth)acryloyl). In this case, the resin composition preferably further contains a curing agent (crosslinking agent) (as needed, in combination with a curing accelerator).

Non-limiting examples of the curing agent include organic amine compounds, dicyandiamides, and derivatives thereof; imidazoles such as 2-methylimidazole and 2-ethyl-4-methylimidazole, and derivatives thereof; divalent phenol compounds such as bisphenol-A, bisphenol-F, brominated bisphenol-A, naphthalenediol, and 4,4'-biphenol; novolak resins or aralkyl-phenolic resins resulting from condensation between a phenol or a naphthol and formaldehyde or a xylylene glycol; acid anhydrides such as succinic anhydride, maleic anhydride, phthalic anhydride, hexahydrophthalic anhydride, methylated hexahydrophthalic anhydride, nadic anhydride, hydrogenated nadic anhydride, trimellitic anhydride, and pyromellitic anhydride; hydrazide compounds such as adipic acid hydrazide; and silicone resins having a bifunctional or higher silanol group. The resin composition may contain each of them alone or in combination. Among them, the curing agent for use herein is preferably selected from acid anhydrides such as hexahydrophthalic anhydride, methylated hexahydrophthalic anhydride, and hydrogenated nadic anhydride.

Non-limiting examples of the curing accelerator include tertiary amines and salts thereof, imidazoles and salts thereof, organic phosphine compounds and salts thereof, and organometallic salts such as zinc octoate and tin octoate. The resin composition may contain each of them alone or in combination.

Compound (B) Capable of Absorbing or Scattering Light at One or More Wavelengths from 200 to 450 nm

Non-limiting examples of the compound capable of absorbing or scattering light at one or more wavelengths from 200 to 450 nm for use in the present invention include compounds capable of absorbing light at the wavelength(s) (hereinafter also referred to as "light absorbers"), and compounds capable of scattering light at the wavelength(s) (hereinafter also referred to as "light scattering agents"). The resin composition may contain each of them alone or in combination.

Light Absorbers

The light absorbers are compounds that are capable of absorbing light at one or more wavelengths from 200 to 450 nm, converting the light typically into heat, and thereby restraining the light at the wavelength(s) from passing through the mold. Non-limiting examples of the light absorbers include benzotriazole compounds, benzophenone compounds, benzoxazinone compounds, cyanoacrylate compounds, benzoxazole compounds, melocyanine compounds, and triazine compounds. The resin composition may contain each of them alone or in combination. Among them, the light absorber for use in the present invention is preferably selected from triazine compounds, because these compounds can highly efficiently absorb light at the wavelength(s) and are resistant to the light at the wavelength(s).

Non-limiting examples of the triazine compounds include 2,4,6-tris(2-hydroxy-4-hexyloxy-3-methylphenyl)-1,3,5-triazine, 2-(4,6-diphenyl-1,3,5-triazin-2-yl)-5-[2-(2-ethylhexanoyloxy)ethoxy]phenol, 2-(4-hexyloxy-2-hydroxyphenyl)-4,6-diphenyl-1,3,5-triazine, 2-(4-octyloxy-2-hydroxyphenyl)-4,6-di(2,5-dimethylphenyl)-1,3,5-triazine, 2-(4-butoxy-2-hydroxyphenyl)-4,6-di(4-butoxyphenyl)-1,3,5-triazine, 2-(4-butoxy-2-hydroxyphenyl)-4,6-di(2,4-dibutoxyphenyl)-1,3,5-triazine, 2-(4-[3-(2-ethylhexyloxy)-2-hydroxypropoxy]-2-hydroxyphenyl)-4,6-di(2,4-dimethylphenyl)-1,3,5-triazine, 2-[4-(3-dodecyloxy-2-hydroxypropoxy)-2-hydroxyphenyl]-4,6-di(2,4-dimethylphenyl)-1,3,5-triazine, 2,4-di(4-butoxy-2-hydroxyphenyl)-6-(4-butoxyphenyl)-1,3,5-triazine, and 2,4-di(4-butoxy-2-hydroxyphenyl)-6-(2,4-dibutoxyphenyl)-1,3,5-triazine.

Light Scattering Agents

The light scattering agents are compounds that are capable of scattering or reflecting, by physical mechanism, light at one or more wavelengths from 200 to 450 nm and thereby restraining the light at the wavelength(s) from passing through the mold. Non-limiting examples of the light scattering agents include nanocarbons such as carbon nanotubes and graphene; and metal oxides such as silica, titanium oxides, zinc oxide, and kaolin, and derivatives of them whose surface is modified typically with a silicone. The resin composition may contain each of them alone or in combination.

The light scattering agents may have any shape not limited, which is exemplified typically by globular (such as fine spherical, approximately spherical, and ellipsoidal) shapes, polyhedral shapes, rodlike (such as cylindrical and prismatic) shapes, tabular shapes, scaly shapes, and amorphous shapes.

The light scattering agents each have an average particle diameter of typically 5 nm to 5 $\mu$m, preferably 100 nm to 1 $\mu$m, and particularly preferably 100 to 500 nm. A light scattering agent having an average particle diameter smaller than the range tends to be transparent in the wavelength region of from 200 to 450 nm and to less effectively scatter or reflect light at the wavelength(s). In contrast, a light scattering agent having an average particle diameter

greater than the range tends to excessively scatter or reflect light and to cause the resin composition to offer a significantly lower transmittance of light at the wavelength(s). This tends to offer less advantageous effects of the present invention, because, of the mold, the protrusions and the base portion hardly have a sufficient difference from each other in transmittance of light at the wavelength(s) merely by the difference in thickness between the two portions. The average particle diameter herein is a median diameter (d50) determined by laser diffraction scattering analysis.

Resin Composition for Replica Mold Formation

The resin composition for replica mold formation according to the present invention (hereinafter also referred to as "resin composition") contains the resin (A), and the compound (B) capable of absorbing or scattering light at one or more wavelengths from 200 to 450 nm.

The compound (B) is present in a proportion in the range of 0.5 to 50 parts by weight per 100 parts by weight of the resin (A). The proportion is preferably adjusted as appropriate according to the function of the compound (B). For example, assume that a light absorber is used as the compound (B), where the light absorber is a compound that is capable of absorbing light at one or more wavelengths from 200 to 450 nm. In this case, the compound (B) is present in a proportion of preferably 0.5 to 10 parts by weight, more preferably 1 to 8 parts by weight, particularly preferably 2 to 6 parts by weight, and most preferably 2 to 5 parts by weight, per 100 parts by weight of the resin (A). Assume that a light scattering agent is used as the compound (B), where the light scattering agent is a compound that is capable of scattering light at one or more wavelengths from 200 to 450 nm. In this case, the compound (B) is present in a proportion of preferably 1 to 40 parts by weight, particularly preferably 5 to 40 parts by weight, and most preferably 5 to 20 parts by weight, per 100 parts by weight of the resin (A).

The resin composition preferably contains the compound (B) in such a proportion as to give a cured product or solidified product having a transmittance of light at the wavelength(s) of typically about 1% to about 90% (preferably 5% to 70%, and particularly preferably 10% to 50%), provided that the transmittance of light at one or more wavelengths from 200 to 450 nm in a cured product or solidified product of a resin composition devoid of compounds (B) is defined as 100%; and that the two cured products or solidified products are identical in thickness.

Assume that a mold is formed using the resin composition containing the compound (B) in a proportion within the range. Due to the difference in thickness between protrusions and base portion thereof, the mold can have a difference between the two types of portions in transmittance of light at one or more wavelengths from 200 to 450 nm, namely, can have a difference in quantity of light at the wavelength(s) which reaches a coated film of a photocurable composition. Thus, the protrusions have a lower transmittance of the light at the wavelength(s) as compared with the base portion. Using the mold, a pattern can be formed by rapidly curing other portions than a residual layer in the coated film of a photocurable composition, while suppressing the residual layer from being cured, and the residual layer, which is uncured or semi-cured, can be removed by washing. The resin composition, if containing the compound (B) in an excessively high proportion, tends to cause the patterned portion to be insufficiently cured. In contrast, if the resin composition contains the compound (B) in an excessively low proportion, it tends to be difficult to cure the patterned portion with restraining the residual layer portion from being cured. In this case, if the patterned portion is to be sufficiently cured, the residual layer portion is also cured, and this tends to impede the removal of the residual layer by washing. In contrast, if the residual layer portion is to be held in an uncured or semi-cured state, the patterned portion tends to be cured insufficiently.

In addition to the components, the resin composition according to the present invention may further contain any other component or components as needed. For example, the resin composition may further contain an organic solvent so as to adjust its viscosity. Non-limiting examples of the organic solvent include saturated or unsaturated hydrocarbon solvents such as pentane, hexane, heptane, octane, and petroleum ether; aromatic hydrocarbon solvents such as benzene, toluene, and xylenes; ketones such as acetone, methyl ethyl ketone, methyl isobutyl ketone, methyl n-amyl ketone, and cyclohexanone; alcohols such as methanol, ethanol, and n-butanol; and ethers such as 1,2-dimethoxyethane, tetrahydrofuran, and dioxane. The resin composition may contain each of them alone or in combination. The resin composition preferably has a viscosity (at 25°C) being adjusted typically to about 1 to about 100 mPa·s. The viscosity of the resin composition can be measured typically using a digital viscometer (model DVU-EII, from Tokimec, Inc.) with a standard rotor of 1°34' × R24, at a temperature of 25°C, and a number of revolutions of 0.5 to 10 rpm.

The resin composition according to the present invention may further contain one or more other components such as polymerization initiators, polymerization inhibitors, silane coupling agents, antioxidants, photostabilizers, plasticizers, antifoaming agents, ion adsorbents, coloring materials, fluorophors, and release agents.

Replica Mold

The replica mold according to the present invention includes a cured product or solidified product of the resin composition for replica mold formation. The replica mold according to the present invention preferably structurally includes

a substrate and the cured product or solidified product of the resin composition for replica mold formation disposed on the substrate, in which the cured product or solidified product has a relief (convex-concave) structure on its surface.

The replica mold according to the present invention can be produced typically by transferring a pattern from a master mold to the resin composition according to the present invention.

More specifically, in an embodiment, the replica mold can be produced by pressing the master mold against a coated film of the resin composition coated on the substrate, curing or solidifying the coated film of the resin composition, and removing the master mold.

In another embodiment, the replica mold can be produced by applying the resin composition directly to the master mold, bringing the substrate into contact with the applied coated film of the resin composition, then curing or solidifying the coated film of the resin composition, and removing the master mold.

The substrate for use herein is preferably selected from substrates having a transmittance of 90% or more with respect to light at one or more wavelengths from 200 to 450 nm and is advantageously selected from substrates made of quartz or glass. The transmittance of light at the wavelength(s) is determined by applying light at the wavelength(s) to a test specimen and measuring the transmittance of the test specimen with respect to the light using a spectrophotometer, where the test specimen is the substrate having a thickness of 1 mm.

The substrate has a thickness of typically about 50 μm to about 5 mm.

The coated film of the resin composition can be formed typically by applying the resin composition to a surface to be coated, and, when the resin composition contains a solvent, removing the solvent by evaporation. The resin composition may be applied using a technique such as spraying, spin coating, or screen process printing. The coated film of the resin composition has a thickness of typically about 0.1 to about 10 μm.

The master mold is pressed against the coated film of the resin composition preferably with heating (heating typically at 70°C to 200°C) of at least one of the resin composition and the master mold. This is preferred so as to allow the resin composition to have better conformability to the fine relief pattern of the master mold and to fill the relief pattern satisfactorily. Thereafter, the resin composition, when containing a thermoplastic resin as the resin (A), is cooled down to a temperature lower than the softening point or melting point of the resin (A) and is thereby solidified, followed by removal of the master mold. The resin composition, when containing a thermosetting resin as the resin (A), is subjected to heat treatment and is thereby cured, followed by removal of the master mold. This can give a replica mold including the cured product or solidified product of the resin composition and having a fine relief pattern on its surface, where the fine relief pattern is transferred from the master mold.

As used herein, the term "master mold" refers to a structure that is made of a material such as silicon (Si), quartz, or a metal, has a fine relief structure (shape) on its surface, is also called a master or matrix, and is very expensive. The present invention contributes to significant cost reduction, because a replica mold is formed from such expensive master mold, and patterning is performed using the replica mold.

Of the replica mold according to the present invention, the protrusions have a thickness of typically 1 to 100 μm; and the base portion have a thickness of typically 0.05 to 2 μm. The difference in thickness between the protrusions and the base portion is typically 1.5 to 95 μm. The relief pattern of the replica mold according to the present invention has a line-and-space (L/S) of typically about 0.5 μm/0.5 μm to about 20 μm/100 μm.

The replica mold according to the present invention contains the compound (B) capable of absorbing or scattering light at one or more wavelengths from 200 to 450 nm and can thereby have a difference in transmittance of light at the wavelength(s) between the protrusions and the base portion therein. The ratio of the transmittance of light in the base portion to the transmittance of light in the protrusions is typically 1.1 to 100, preferably 1.5 to 50, and particularly preferably 2 to 30.

The transmittance (T) of the replica mold according to the present invention of light at one or more wavelengths from 200 to 450 nm, the concentration (C) of the compound (B) capable of absorbing or scattering light at the wavelength(s), the thickness (L) of the replica mold, and the molar absorption coefficient (ε) of the resin (A) meet the following relational expression, where the resin (A) and the compound (B) are contained in the replica mold. Accordingly, the ratio of the transmittance in the base portion to the transmittance in the protrusions, each with respect to light at one or more wavelengths from 200 to 450 nm, can be controlled by adjusting the content or proportion of the compound (B). The relational expression is expressed as follows:

$$T = 10^{-\varepsilon CL}$$

Patterning Method

The patterning method according to the present invention includes a) pressing the replica mold against a coated film of a photocurable composition, b) curing the coated film, c) removing the replica mold after the step b), and removing

a residual layer by washing after the step c).

More specifically, the patterning method according to the present invention includes steps (I), (II), (III), and (IV) as follows (see FIG. 1):

(I) pressing the replica mold against a coated film of a photocurable composition;
(II) curing the photocurable composition;
(III) removing the replica mold; and
(IV) removing a residual layer by washing.

The photocurable composition preferably contains a curable compound and a photoinitiator.

Non-limiting examples of the curable compound include cationically curable compounds such as epoxides (epoxy compounds) and oxetane compounds; and radically curable compounds such as (meth)acrylates.

The epoxides include cycloaliphatic epoxides, aromatic epoxides, and aliphatic epoxides.

Cycloaliphatic Epoxides

The cycloaliphatic epoxides are exemplified by, but not limited to, known or common compounds having one or more alicycles and one or more epoxy groups in the molecule, and non-limiting examples thereof include compounds as follows:

(1) compounds having a cycloaliphatic epoxy group in the molecule, where the term "cycloaliphatic epoxy group" as used herein refers to an epoxy group containing an oxygen atom bonded in a triangular arrangement to two adjacent carbon atoms constituting an alicycle; and a non-limiting example of the cycloaliphatic epoxy group is cyclohexene oxide group;
(2) compounds containing an epoxy group bonded directly through a single bond to an alicycle; and
(3) glycidyl ether epoxides which are compounds containing an alicycle and a glycidyl ether group in the molecule.

Non-limiting examples of the compounds (1) containing a cycloaliphatic epoxy group in the molecule include compounds represented by Formula (i):

[Chem. 2]

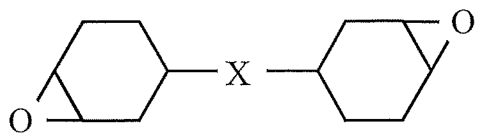

(i)

In Formula (i), X is selected from a single bond and a linkage group (divalent group containing one or more atoms). Non-limiting examples of the linkage group include divalent hydrocarbon groups, alkenylene groups with part or all of carbon-carbon double bond(s) being epoxidized, carbonyl, ether bond, ester bond, carbonate group, amido, and groups each including two or more of them linked to each other.

Non-limiting examples of the divalent hydrocarbon groups include $C_1$-$C_{18}$ linear or branched alkylenes and $C_3$-$C_{18}$ divalent alicyclic hydrocarbon groups. Non-limiting examples of the $C_1$-$C_{18}$ linear or branched alkylenes include methylene, methylmethylene, dimethylmethylene, ethylene, propylene, and trimethylene. Non-limiting examples of the $C_3$-$C_{18}$ divalent alicyclic hydrocarbon groups include cycloalkylenes (including cycloalkylidenes) such as 1,2-cyclopentylene, 1,3-cyclopentylene, cyclopentylidene, 1,2-cyclohexylene, 1,3-cyclohexylene, 1,4-cyclohexylene, and cyclohexylidene.

Non-limiting examples of the alkylene moieties in the alkenylenes with part or all of carbon-carbon double bond(s) being epoxidized (hereinafter also referred to as "epoxidized alkenylenes") include $C_2$-$C_8$ linear or branched alkenylenes such as vinylene, propenylene, 1-butenylene, 2-butenylene, butadienylene, pentenylene, hexenylene, heptenylene, and octenylene. In particular, of the epoxidized alkenylenes, alkylenes with all carbon-carbon double bond(s) being epoxidized are preferred, and $C_2$-$C_4$ alkenylenes with all carbon-carbon double bond(s) being epoxidized are more preferred.

Representative, but non-limiting examples of the cycloaliphatic epoxides represented by Formula (i) include (3,4,3',4'-diepoxy)bicyclohexyl, bis(3,4-epoxycyclohexylmethyl) ether, 1,2-epoxy-1,2-bis(3,4-epoxycyclohex-1-yl)ethane, 2,2-bis(3,4-epoxycyclohex-1-yl)propane, 1,2-bis(3,4-epoxycyclohex-1-yl)ethane, and compounds represented by Formulae (i-1) to (i-10) below. In Formula (i-5), L is selected from $C_1$-$C_8$ alkylenes, of which $C_1$-$C_3$ linear or branched alkylenes such as methylene, ethylene, propylene, and isopropylene are preferred. In Formulae (i-5), (i-7), (i-9), and (i-10), $n^1$ to $n^8$ each independently represent an integer of 1 to 30. Formulae (i-1) to (i-10) are expressed as follows:

[Chem. 3]

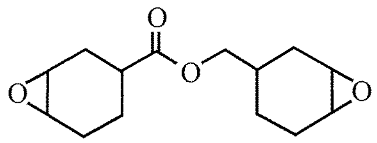

(i-1)

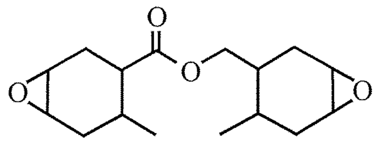

(i-2)

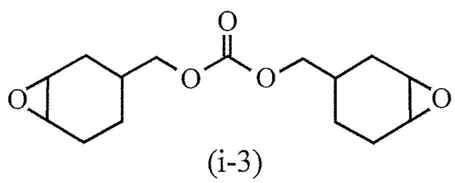

(i-3)

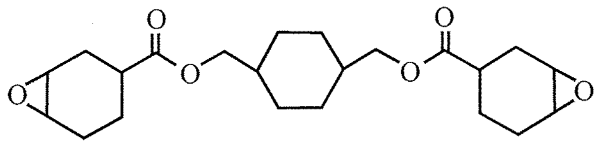

(i-4)

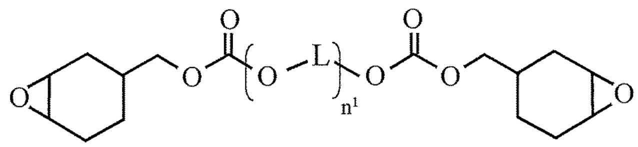

(i-5)

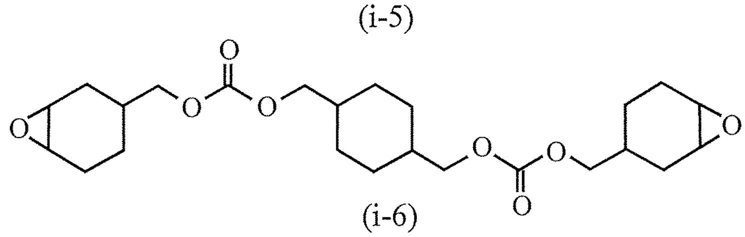

(i-6)

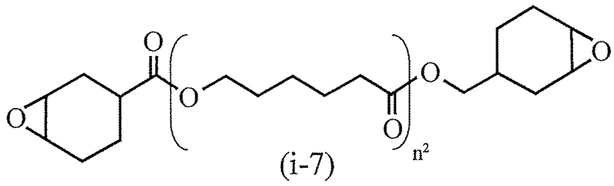

(i-7)

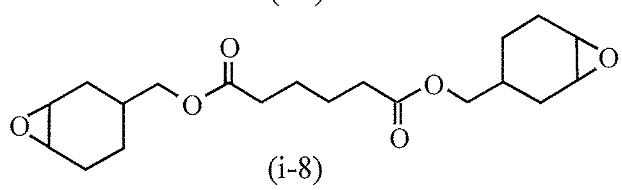

(i-8)

[Chem. 4]

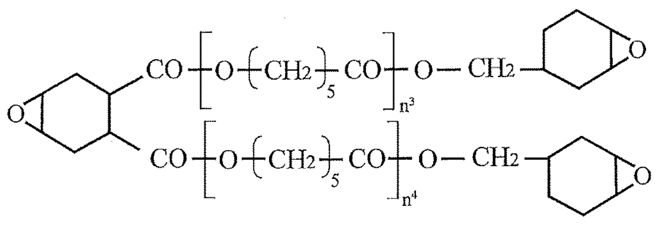

(i-9)

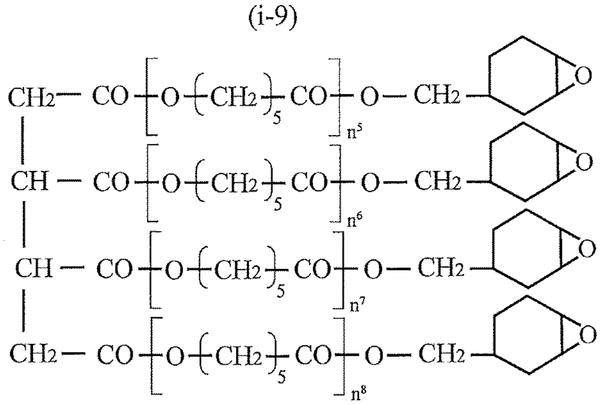

(i-10)

Non-limiting examples of the compounds (2) containing an epoxy group bonded directly through a single bond to an alicycle include compounds represented by Formula (ii):

[Chem. 5]

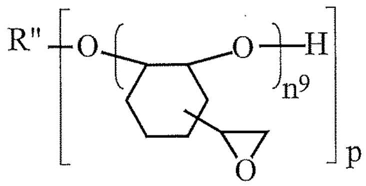

(ii)

In Formula (ii), R" represents a group (p-valent organic group) resulting from removal of "p" hydroxy groups (-OH) from the structural formula of a p-hydric alcohol; and p and $n^9$ each independently represent a natural number. Non-limiting examples of the p-hydric alcohol ($R''(OH)_p$) include polyhydric alcohols such as 2,2-bis(hydroxymethyl)-1-butanol, of which $C_1$-$C_{15}$ alcohols are typified. The number p is preferably from 1 to 6, and $n^9$ is preferably from 1 to 30. When p is 2 or more, two or more occurrences of $n^9$ of the groups in the brackets (outer square brackets) may be identical or different. Specifically, a non-limiting example of the compounds represented by Formula (ii) is the adduct of 1,2-epoxy-4-(2-oxiranyl)cyclohexane and 2,2-bis(hydroxymethyl)-1-butanol (such as EHPE 3150 (trade name, from Daicel Corporation)).

Non-limiting examples of the compounds (3) containing an alicycle and a glycidyl ether group in the molecule include glycidyl ethers of alicyclic alcohols (in particular, of alicyclic polyhydric alcohols). More specifically, non-limiting examples of the compounds (3) include hydrogenated bisphenol-A epoxides, which are compounds resulting from hydrogenation of bisphenol-A epoxides, such as 2,2-bis[4-(2,3-epoxypropoxy)cyclohexyl]propane and 2,2-bis[3,5-dimethyl-4-(2,3-epoxypropoxy)cyclohexyl]propane; hydrogenated bisphenol-F epoxides, which are compounds resulting from hydrogenation of bisphenol-F epoxides, such as bis[o,o-(2,3-epoxypropoxy)cyclohexyl]methane, bis[o,p-(2,3-epoxypropoxy)cyclohexyl]methane, bis[p,p-(2,3-epoxypropoxy)cyclohexyl]methane, and bis[3,5-dimethyl-4-(2,3-epoxypropoxy)cyclohexyl]methane; hydrogenated biphenol epoxides; hydrogenated phenol novolak epoxides; hydrogenated cresol novolak epoxides; hydrogenated cresol novolak epoxides of bisphenol-A; hydrogenated naphthalene epoxides; and compounds resulting from hydrogenation of epoxides derived from trisphenolmethane.

Aromatic Epoxides

Non-limiting examples of the aromatic epoxides include epi-bis glycidyl ether epoxy resins resulting from condensation between an epihalohydrin and a bisphenol (such as bisphenol-A, bisphenol-F, bisphenol-S, or fluorene-bisphenol); high-molecular-weight epi-bis glycidyl ether epoxy resins resulting from addition reaction of these epi-bis glycidyl ether epoxy resins further with the bisphenol; novolak-alkyl glycidyl ether epoxy resins resulting from condensation between a phenol (such as phenol, cresol, xylenol, resorcinol, catechol, bisphenol-A, bisphenol-F, or bisphenol-S) and an aldehyde (such as formaldehyde, acetaldehyde, benzaldehyde, hydroxybenzaldehyde, or salicylaldehyde) to give polyhydric alcohols, and further condensation between the polyhydric alcohols and the epihalohydrin; and epoxides each having a fluorene ring to which two phenol skeletons are bonded at the 9-position, in which glycidyls are independently bonded directly or through an alkyleneoxy group to oxygen atoms resulting from removal of hydrogen atoms from the hydroxy groups of the two phenol skeletons.

Aliphatic Epoxides

Non-limiting examples of the aliphatic epoxides include glycidyl ethers of q-hydric alcohols devoid of cyclic structures, where q is a natural number; glycidyl esters of mono-valent or poly-valent carboxylic acids (such as acetic acid, propionic acid, butyric acid, stearic acid, adipic acid, sebacic acid, maleic acid, and itaconic acid); epoxidized products of fats and oils having a double bond, such as epoxidized linseed oil, epoxidized soybean oil, and epoxidized castor oil; and epoxidized products of polyolefins (including polyalkadienes), such as epoxidized polybutadienes. Non-limiting examples of the q-hydric alcohols devoid of cyclic structures include monohydric alcohols such as methanol, ethanol, 1-propyl alcohol, isopropyl alcohol, and 1-butanol; divalent alcohols such as ethylene glycol, 1,2-propanediol, 1,3-propanediol, 1,4-butanediol, neopentyl glycol, 1,6-hexanediol, diethylene glycol, triethylene glycol, tetraethylene glycol, dipropylene glycol, polyethylene glycols, and polypropylene glycols; and trihydric or higher polyhydric alcohols such as glycerol, diglycerol, erythritol, trimethylolethane, trimethylolpropane, pentaerythritol, dipentaerythritol, and sorbitol. The q-hydric alcohol may also be selected typically from polyether polyols, polyester polyols, polycarbonate polyols, and polyolefin polyols.

Non-limiting examples of the oxetane compounds include 3,3-bis(vinyloxymethyl)oxetane, 3-ethyl-3-hydroxymethyloxetane, 3-ethyl-3-(2-ethylhexyloxymethyl)oxetane, 3-ethyl-3-(hydroxymethyl)oxetane, 3-ethyl-3-[(phenoxy)methyl]oxetane, 3-ethyl-3-(hexyloxymethyl)oxetane, 3-ethyl-3-(chloromethyl)oxetane, 3,3-bis(chloromethyl)oxetane, 1,4-bis[(3-ethyl-3-oxetanylmethoxy)methyl]benzene, bis([1-ethyl(3-oxetanyl)]methyl) ether, 4,4'-bis[(3-ethyl-3-oxetanyl)methoxymethyl]bicyclohexyl, 4,4'-bis[3-ethyl-(3-oxetanyl)methoxymethyl]biphenyl, 1,4-bis[(3-ethyl-3-oxetanyl)methoxymethyl]cyclohexane, 1,4-bis([(3-ethyl-3-oxetanyl)methoxy]methyl)benzene, 3-ethyl-3([(3-ethyloxetan-3-yl)methoxy]methyl)oxetane, and xylylenebisoxetane. Such oxetane compounds for use in the present invention may be available as commercial products such as ARON OXETANE OXT-121 and ARON OXETANE OXT-221 (trade names, from Toagosei Co., Ltd.); and ETERNACOLL OXBP (trade name, from Ube Industries, Ltd.).

The (meth)acrylates are compounds containing one or more (meth)acryloyl groups in the molecule. As used herein, the term "(meth)acryloyl" refers to acryl and/or methacryl; and the same is also true for other similar terms such as "(meth)acrylate".

The (meth)acrylates may each contain acryloyl groups and methacryloyl groups in the molecule in any number (total number) not limited, but each contain preferably 2 or more (e.g., 2 to 15), more preferably 3 or more (e.g., 3 to 12), and furthermore preferably 6 or more (e.g., 6 to 10) of these groups.

The (meth)acrylates each have a molecular weight of typically 300 to 13000, preferably 400 to 13000, more preferably 500 to 10000, and furthermore preferably 500 to 3000.

Non-limiting examples of the (meth)acrylates include monofunctional (meth)acrylates such as methyl (meth)acrylate, ethyl (meth)acrylate, n-butyl (meth)acrylate, isobutyl (meth)acrylate, t-butyl (meth)acrylate, n-hexyl (meth)acrylate, 2-ethylhexyl (meth)acrylate, isodecyl (meth)acrylate, n-lauryl (meth)acrylate, n-stearyl (meth)acrylate, phenylphenol ethoxy(meth)acrylate, phenylphenol diethoxy(meth)acrylate, phenylphenol pentaethoxy(meth)acrylate, n-butoxyethyl (meth)acrylate, butoxy diethylene glycol (meth)acrylate, methoxy triethylene glycol (meth)acrylate, methoxy poly(ethylene glycol) (meth)acrylates, cyclohexyl (meth)acrylate, dicyclopentenyloxyethyl (meth)acrylate, tetrahydrofurfuryl (meth)acrylate, benzyl (meth)acrylate, 2-phenoxyethyl (meth)acrylate, isobornyl (meth)acrylate, 2-hydroxyethyl (meth)acrylate, polycaprolactone-modified 2-hydroxyethyl (meth)acrylate, 2-hydroxypropyl (meth)acrylate, 2-hydroxybutyl (meth)acrylate, dimethylaminoethyl (meth)acrylate, diethylaminoethyl (meth)acrylate, (meth)acrylic acid, 2-(meth)acryloyloxyethyl succinate, 2-(meth)acryloyloxyethyl hexahydrophthalate, 2-(meth)acryloyloxyethyl-2-hydroxypropyl phthalate, 2-(meth)acryloyloxyethyl acid phosphate, (meth)acryloylmorpholine, trifluoroethyl (meth)acrylate, perfluorooctylethyl (meth)acrylate, isoamyl (meth)acrylate, isomyristyl (meth)acrylate, $\gamma$-(meth)acryloyloxypropyltrimethoxysilane, 2-(meth)acryloyloxyethyl isocyanate, 2-(2-(meth)acryloyloxyethyloxy)ethyl isocyanate, and 3-(meth)acryloyloxypropyltriethoxysilane, and derivatives of them; bifunctional (meth)acrylates such as 2-hydroxy-3-(meth)acryloyloxypropyl

(meth)acrylate, tricyclodecanedimethanol di(meth)acrylate, glycerol di(meth)acrylate, ethylene glycol di(meth)acrylate, diethylene glycol di(meth)acrylate, triethylene glycol di(meth)acrylate, tetraethylene glycol di(meth)acrylate, propylene glycol di(meth)acrylate, dipropylene glycol di(meth)acrylate, neopentyl glycol di(meth)acrylate, 1,4-butanediol di(meth)acrylate, 1,6-hexanediol di(meth)acrylate, 1,9-nonanediol di(meth)acrylate, 1,10-decanediol di(meth)acrylate, 9,9-bis[4-(2-(meth)acryloyloxyethoxy)phenyl]fluorene, 2,2-bis[4-((meth)acryloyloxydiethoxy)phenyl]propane, and derivatives of them; trifunctional or higher multifunctional (meth)acrylates such as ethoxylated isocyanuric acid tri(meth)acrylate, ε-caprolactone-modified tris(2-(meth)acryloyloxyethyl) isocyanurate, glycerol tri(meth)acrylate, ethoxylated glycerol tri(meth)acrylate, propoxylated glycerol tri(meth)acrylate, pentaerythritol tri(meth)acrylate, trimethylolpropane tri(meth)acrylate, tri(meth)acrylate of the adduct of trimethylolpropane and 3 moles of ethylene oxide, tri(meth)acrylate of the adduct of trimethylolpropane and 3 moles of propylene oxide, tri(meth)acrylate of the adduct of trimethylolpropane and 6 moles of ethylene oxide, tri(meth)acrylate of the adduct of trimethylolpropane and 6 moles of propylene oxide, ditrimethylolpropane tetra(meth)acrylate, ethoxylated pentaerythritol tetra(meth)acrylate, pentaerythritol tetra(meth)acrylate, dipentaerythritol poly(meth)acrylates (such as dipentaerythritol hexa(meth)acrylate, and hexa(meth)acrylate of the adduct of dipentaerythritol and caprolactone), and derivatives of them; and any other monofunctional or multifunctional (meth)acrylates such as polyester (meth)acrylates, polyether (meth)acrylates, acrylic (meth)acrylate, urethane (meth)acrylates, epoxy (meth)acrylates, polyalkadiene (meth)acrylates (such as polybutadiene (meth)acrylates), melamine (meth)acrylates, and polyacetal (meth)acrylates.

The category photoinitiator includes cationic photoinitiators (photo-cationic polymerization initiators) and radical photoinitiators (photo-radical polymerization initiators). These are preferably selected according to the curable compound contained in the photocurable composition, and the photocurable composition may contain each of them alone or in combination.

The polymerization initiator may be present in a proportion of typically 0.1 to 20.0 parts by weight, preferably 1.0 to 15.0 parts by weight, and particularly preferably 1.0 to 10.0 parts by weight, per 100 parts by weight of the curable compound contained in the photocurable composition (when two or more curable compounds are contained, per 100 parts by weight of the totality of them).

Cationic Photoinitiators

The cationic photoinitiators are compounds that generate an acid upon application of light to initiate curing reaction of a cationically curable compound contained in the photocurable composition. The cationic photoinitiators each include a cationic moiety that absorbs light, and an anionic moiety that serves as an acid source.

Non-limiting examples of the cationic photoinitiators include diazonium salt compounds, iodonium salt compounds, sulfonium salt compounds, phosphonium salt compounds, selenium salt compounds, oxonium salt compounds, ammonium salt compounds, and bromine salt compounds.

Among them, the cationic photoinitiator for use in the present invention is preferably selected from sulfonium salt compounds, so as to form a cured product with excellent curability. Non-limiting examples of the cationic moieties of the sulfonium salt compounds include arylsulfonium ions such as (4-hydroxyphenyl)methylbenzylsulfonium ion, triphenylsulfonium ion, diphenyl[4-(phenylthio)phenyl]sulfonium ion, 4-(4-biphenylylthio)phenyl-4-biphenylylphenylsulfonium ion, and tri-p-tolylsulfonium ion, of which triarylsulfonium ions are typified.

Non-limiting examples of the anionic moieties of the cationic photoinitiators include $[(Y)_sB(Phf)_{4-s}]^-$ (where Y represents phenyl or biphenylyl; Phf represents a group resulting from substitution of at least one of hydrogens of a phenyl group with at least one selected from perfluoroalkyls, perfluoroalkoxys, and halogens; and s represents an integer of 0 to 3), $BF_4^-$, $[(Rf)_tPF_{6-t}]^-$ (where Rf represents a group resulting from substitution of 80% or more of a phenyl group with fluorines; and t represents an integer of 0 to 5), $AsF_6^-$, $SbF_6^-$, and $SbF_5OH^-$.

Non-limiting examples of the cationic photoinitiators for use herein include (4-hydroxyphenyl)methylbenzylsulfonium tetrakis(pentafluorophenyl)borate, 4-(4-biphenylylthio)phenyl-4-biphenylylphenylsulfonium tetrakis(pentafluorophenyl)borate, 4-(phenylthio)phenyldiphenylsulfonium phenyltris(pentafluorophenyl)borate, [4-(4-biphenylylthio)phenyl]-4-biphenylylphenylsulfonium phenyltris(pentafluorophenyl)borate, diphenyl[4-(phenylthio)phenylsulfonium] hexafluoroantimonate, diphenyl[4-(phenylthio)phenyl]sulfonium tris(pentafluoroethyl)trifluorophosphate, diphenyl[4-(phenylthio)phenyl]sulfonium tetrakis(pentafluorophenyl)borate, diphenyl[4-(phenylthio)phenyl]sulfonium hexafluorophosphate, 4-(4-biphenylylthio)phenyl-4-biphenylylphenylsulfonium tris(pentafluoroethyl)trifluorophosphate, bis[4-(diphenylsulfonio)phenyl]sulfide phenyltris(pentafluorophenyl)borate, and [4-(2-thioxanthonylthio)phenyl]phenyl-2-thioxanthonylsulfonium phenyltris(pentafluorophenyl)borate; as well as commercial products typically under the trade names of: CYRACURE UVI-6970, CYRACURE UVI-6974, CYRACURE UVI-6990, and CYRACURE UVI-950 (each from Union Carbide Corporation, U.S.A.), Irgacure 250, Irgacure 261, and Irgacure 264 (each from BASF SE); CG-24-61 (from Ciba Geigy Ltd.); OPTOMER SP-150, OPTOMER SP-151, OPTOMER SP-170, and OPTOMER SP-171 (each from ADEKA CORPORATION); DAICAT II (from Daicel Corporation); UVAC 1590 and UVAC 1591 (each from DAICEL-CYTEC Company, Ltd.); CI-2064, CI-2639, CI-2624, CI-2481, CI-2734, CI-2855, CI-2823, CI-2758, and CIT-1682 (each from Nippon Soda

Co., Ltd.); PI-2074 (from Rhodia, toluylcumyliodonium tetrakis(pentafluorophenyl)borate); FFC 509 (from 3M); BBI-102, BBI-101, BBI-103, MPI-103, TPS-103, MDS-103, DTS-103, NAT-103, and NDS-103 (each from Midori Kagaku Co., Ltd.); CD-1010, CD-1011, and CD-1012 (each from Sartomer Company, Inc., U.S.A.); and CPI-100P and CPI-101A (each from San-Apro Ltd.).

Radical Photoinitiators

Non-limiting examples of the radical photoinitiators include benzophenone, acetophenonebenzil, benzil dimethyl ketone, benzoin, benzoin methyl ether, benzoin ethyl ether, benzoin isopropyl ether, dimethoxyacetophenone, 2,2-dimethoxy-2-phenylacetophenone (available typically under the trade name of Irgacure 641 from Ciba Geigy Ltd.), diethoxyacetophenone, diphenyl disulfite, methyl o-benzoylbenzoate, ethyl 4-dimethylaminobenzoate (available typically under the trade name of KAYACURE EPA from Nippon Kayaku Co., Ltd.), 2,4-diethylthioxanthone (available typically under the trade name of KAYACURE DETX from Nippon Kayaku Co., Ltd.), 2-methyl-1-[4-(methyl)phenyl]-2-morpholinopropanone-1 (available typically under the trade name of Irgacure 907 from Ciba Geigy Ltd.), 1-hydroxycyclohexyl phenyl ketone (available typically under the trade name of Irgacure 184 from Ciba Geigy Ltd.), 2-dimethylamino-2-(4-morpholino)benzoyl-1-phenylpropane and other 2-amino-2-benzoyl-1-phenylalkane compounds, tetra(t-butylperoxycarbonyl)benzophenone, benzil, 2-hydroxy-2-methyl-1-phenyl-propan-1-one, 4,4'-bis(diethylamino)benzophenone and other aminobenzene derivatives, 2,2'-bis(2-chlorophenyl)-4,5,4',5'-tetraphenyl-1,2'-biimidazole (available typically under the trade name of B-CIM from Hodogaya Chemical Co., Ltd.) and other imidazole compounds, 2,6-bis(trichloromethyl)-4-(4-methoxynaphth-1-yl)-1,3,5-triazine and other halomethylated triazine compounds, and 2-trichloromethyl-5-(2-benzofur-2-yl-ethenyl)-1,3,4-oxadiazole and other halomethyloxadiazole compounds. The photocurable composition may further contain a photosensitizer as needed.

The photocurable composition can be produced typically by uniformly blending the curable compound, the photoinitiator, and, as needed, one or more other components using a commonly known mixing device. Non-limiting examples of the other components include solvents, silane coupling agents, antioxidants, photostabilizers, plasticizers, antifoaming agents, ion adsorbents, coloring materials, fluorophors, and release agents. Non-limiting examples of the mixing device include planetary centrifugal mixers, homogenizers, planetary mixers, triple roll mills, and bead mills. The components may be blended at once or one after another.

The coated film of the photocurable composition can be formed by applying the photocurable composition using a technique such as spraying, spin coating, or screen process printing.

After the replica mold is pressed against the coated film of the photocurable composition, the coated film is cured. The curing of the coated film is performed typically by applying light at one or more wavelengths from 200 to 450 nm through the mold (from the mold side) to the coated film. The light at the wavelength(s) may be applied typically using any of UV-LEDs, high-pressure mercury lamps, ultrahigh pressure mercury lamps, xenon lamps, carbon arc, metal halide lamps, sunlight, and laser. The wavelength of the light to be applied is preferably 260 to 400 nm, and particularly preferably 300 to 400 nm. This is preferred for providing a larger difference in transmittance between the base portion and the protrusions in the mold, due to the difference in thickness between the base portion and the protrusions.

The light at one or more wavelengths from 200 to 450 nm is preferably applied under such conditions that the light is applied to a cumulative irradiance of typically 0.1 to 10 J.

After the light at the wavelength(s) is applied to cure the photocurable composition, the replica mold is removed. A cured product resulting from removal of the replica mold has a relief pattern transferred from the replica mold. The cured product includes a residual layer, which is in an uncured or semi-cured state and can be easily removed by washing with an organic solvent. The organic solvent for use herein is preferably selected according to the formulation of the photocurable composition (in particular, type of the curable compound to be used).

When a cationically curable compound (in particular, an epoxide) is used as the curable compound, the solvent for use herein is advantageously selected typically from glycol solvents, ester solvents, ketone solvents, and mixtures of them. Among them, the solvent is particularly preferably selected from propylene glycol monomethyl ether, propylene glycol monomethyl ether acetate, ethyl lactate, methyl isobutyl ketone, methyl amyl ketone, and mixtures of them.

When a radically curable compound (in particular, a (meth)acrylate) is used as the curable compound, the solvent for use herein is advantageously selected from aqueous solutions of basic compounds. Non-limiting examples of the basic compounds include tetramethylammonium hydroxide, tetraethylammonium hydroxide, tetrabutylammonium hydroxide, sodium methoxide, alkali metal hydroxides, alkali metal metasilicates (hydrates), alkali metal phosphates (hydrates), ammonia water, alkylamines, alkanolamines, and heterocyclic amines.

The patterning method according to the present invention uses the replica mold and enables easy removal of the residual layer by washing. With conventional techniques, the residual layer is removed typically by etching, and this impedes patterning according to the roll-to-roll process. In contrast, the present invention enables easy removal of the residual layer by washing, can employ patterning according to the roll-to-roll process, and can pattern (can form a pattern) efficiently and inexpensively. Examples

The present invention will be illustrated in further detail with reference to several examples below. It should be noted, however, that the examples are by no means intended to limit the scope of the present invention.

Example 1: Preparation of Replica Mold

A resin composition was prepared by dissolving 10 g of cycloolefin copolymer TOPAS 8007S-04 (trade name, available from Polyplastics Co., Ltd.) in 100 g of toluene, and adding 0.20 g of UV absorber ADK STAB LA-F70 (trade name, available from ADEKA CORPORATION).

The prepared resin composition was combined with toluene and thereby adjusted to have a viscosity of 50 mPa·s at 25°C, this was applied by spin coating on a quartz substrate, from which the solvent was removed on a hot plate (80°C), to form a 2-μm thick coated film.

Next, to the coated film, the relief pattern of a master mold was imprinted or transferred by pressing using imprinter NM-0401 (trade name, available from Meisho Kiko Co.) at 160°C for 5 minutes, the imprinted coated film was cooled down to 100°C, demolded from the master mold, and yielded a replica mold (1).

Examples 2 to 9 and Comparative Example 1: Preparation of Replica Mold

Replica molds (2) to (9), and (11) were prepared by a procedure similar to that in Example 1, except for employing the formulations (in part by weight) and layer thicknesses as given in the table below.

Example 10: Preparation of Replica Mold

A resin composition was prepared by mixing 10 g of liquid silicone rubber X-32-1232 (trade name, a polydimethylsiloxane, available from Shin-Etsu Chemical Co., Ltd.), 1 g of curing agent CX-32-1232 (trade name, available from Shin-Etsu Chemical Co., Ltd.), and 3 g of acetone, and adding 0.22 g of UV absorber ADK STAB LA-F70 (trade name, available from ADEKA CORPORATION).

The prepared resin composition was combined with acetone, thereby adjusted to have a viscosity of 50 mPa·s at 25°C, this was applied by spin coating onto a quartz substrate, from which the solvent was removed on a hot plate (80°C), to form a 4-μm thick coated film.

Next, to the coated film, the relief pattern of a master mold was transferred by pressing using imprinter NM-0401 (trade name, available from Meisho Kiko Co.) at 150°C for 2 hours. The resulting film was then cooled down to room temperature (25°C), demolded from the master mold, and yielded a replica mold (10).

Comparative Example 2: Preparation of Replica Mold

A replica mold (12) was prepared by a procedure similar to that in Example 10, except for employing the formulation (in part by weight) given in Table 1.

[Table 1]

TABLE 1

| | | | Examples | | | | | | | | | | Comparative Examples | |
|---|---|---|---|---|---|---|---|---|---|---|---|---|---|---|
| Category | Item | | 1 | 2 | 3 | 4 | 5 | 6 | 7 | 8 | 9 | 10 | 1 | 2 |
| Resin | TOPAS8007S-04 | | 10 | 10 | 10 | 10 | 10 | 10 | 10 | 10 | | | 10 | |
| | TOPAS6013S-04 | | | | | | | | | | 10 | | | |
| | X-32-1232 | | | | | | | | | | | 10 | | 10 |
| | CX-32-1232 | | | | | | | | | | | 1 | | 1 |
| Light absorber | LA-F70 | | 0.20 | 0.50 | 0.20 | 0.20 | 0.20 | 0.20 | 0.10 | 0.10 | 0.20 | 0.22 | | |
| | LA-46 | | | | | | | | 0.20 | 0.40 | | | | |
| Solvent | Toluene | | 100 | 100 | 100 | 100 | 100 | 100 | 100 | 100 | 100 | | 100 | |
| | Acetone | | | | | | | | | | | 3 | | 3 |
| Replica mold configuration | L/S (μm) | | 4/4 | 4/4 | 4/4 | 4/4 | 2/2 | 10/10 | 4/4 | 4/4 | 4/4 | 4/4 | 4/4 | 4/4 |
| | Protrusion thickness (μm) | | 2.0 | 4.0 | 4.0 | 4.0 | 2.0 | 10.0 | 4.0 | 4.0 | 4.0 | 4.0 | 4.0 | 4.0 |
| | Base portion thickness (μm) | | 0.2 | 0.2 | 0.2 | 0.4 | 0.2 | 1.0 | 0.4 | 0.4 | 0.4 | 0.4 | 1.0 | 1.0 |
| UV transmittance ratio | Ratio of transmittance in base portion to transmittance in protrusions | 365 nm | 2.20 | 7.16 | 5.27 | 4.83 | 2.20 | 51.30 | 2.59 | 3.26 | 4.83 | 4.83 | 1.00 | 1.00 |
| | | 254 nm | 1.03 | 1.09 | 1.07 | 1.07 | 1.03 | 1.18 | 2.37 | 5.53 | 1.07 | 1.07 | 1.00 | 1.00 |

The abbreviations given in the table indicate as follows:

Resin

- TOPAS 8007S-04: Cycloolefin copolymer, having a glass transition temperature of 78°C, giving a solidified product (2 mm thick) having a transmittance of light (at a wavelength of 365 nm) of 91%, available from Polyplastics Co., Ltd.
- TOPAS 6013S-04: Cycloolefin copolymer, having a glass transition temperature of 138°C, giving a solidified product (2 mm thick) having a transmittance of light of 91% (at a wavelength of 365 nm), available from Polyplastics Co., Ltd.
- X-32-1232: Polydimethylsiloxane, giving a solidified product (2 mm thick) having a transmittance of light of 90% (at a wavelength of 365 nm), available from Shin-Etsu Chemical Co., Ltd.
- CX-32-1232: Polydimethylsiloxane curing agent, available from Shin-Etsu Chemical Co., Ltd.

Light Absorber

- LA-F70: 2,4,6-Tris(2-hydroxy-4-hexyloxy-3-methylphenyl)-1,3,5-triazine, available from ADEKA CORPORATION
- LA-46: 2-(4,6-Diphenyl-1,3,5-triazin-2-yl)-5-[2-(2-ethylhexanoyloxy)ethoxy]phenol, available from ADEKA CORPORATION

Examples 11 to 24, and Comparative Examples 3 to 6

A silicon wafer coated with a photocurable composition was placed on a stage of nanoimprinter NM-0403 (trade name, available from Meisho Kiko Co.), each of the replica molds (1) to (12) prepared in Examples 1 to 10 and Comparative Examples 1 and 2 was placed on the photocurable composition so that the relief surface of the replica mold was in contact with the photocurable composition, followed by gradual pressurization up to the transfer pressure given in the table (Table 2) over 30 seconds. The coated film was irradiated with light at a wavelength of 365 nm applied through the mold using a high-pressure mercury lamp, with the pressure being held at the transfer pressure, to cure the photocurable composition. The silicon wafer with the cured product was demolded from the mold. Thus, patterning was performed. Next, the patterned silicon wafer was immersed in a solvent for residual layer removal at 25°C for one minute.

The patterned silicon wafer after immersion was evaluated for mold releasability, transfer accuracy, and residual layer removability, so as to evaluate usability of the replica mold.

1) Mold Releasability

The relief shape of a sample patterned silicon wafer was visually observed, and a protrusion with part or all thereof being chipped was evaluated to fail to be demolded. The mold releasability of the sample was evaluated on the basis of the percentage of protrusions that could be demolded according to the criteria as follows:

Good: 90% or more of protrusions could be demolded;
Fair: from 10% to less than 90% of protrusions could be demolded; and
Poor: only less than 10% of protrusions could be demolded.

2) Transfer Accuracy

A sample replica mold was evaluated for transfer accuracy on the basis of the ratio (percentage) of the difference in thickness (height) between protrusions and a base portion in the resulting patterned silicon wafer to the difference in thickness (height) between protrusions and a base portion in the replica mold, according to the criteria as follows:

Good: 90% or more;
Fair: from 10% to less than 90%; and
Poor: less than 10%.

3) Residual Layer Removability

A sample prepared patterned silicon wafer was visually observed and evaluated for residual layer removability according to the criteria as follows:

Good: without residual layer; and
Poor: with residual layer

[Table 2]

TABLE 2

| | | | Examples | | | | | | | | | | | | | | Comparative Examples | | | |
|---|---|---|---|---|---|---|---|---|---|---|---|---|---|---|---|---|---|---|---|---|
| | | | 11 | 12 | 13 | 14 | 15 | 16 | 17 | 18 | 19 | 20 | 21 | 22 | 23 | 24 | 3 | 4 | 5 | 6 |
| Photocurable composition | Curable compound | CELLOXIDE 2021P | 70 | 70 | 70 | 70 | 70 | 70 | 70 | 70 | 70 | 70 | 70 | | | | 70 | | 70 | |
| | | EHPE3150 | 10 | | 10 | 10 | 10 | 10 | 10 | 10 | 10 | 10 | 10 | | | | 10 | | 10 | |
| | | OXT-221 | 20 | 30 | 20 | 20 | 20 | 20 | 20 | 20 | 20 | 20 | 20 | | | | 20 | | 20 | |
| | | d PETIA | | | | | | | | | | | | 20 | 50 | 10 | | 20 | | 20 |
| | | β-CEA | | | | | | | | | | | | | | 20 | | | | |
| | | EBECRYL 150 | | | | | | | | | | | | 80 | 50 | 70 | | 80 | | 80 |
| | Photoinitiator | CPI-110P | 3 | 3 | 3 | 3 | 3 | 3 | 3 | 3 | 3 | 3 | 3 | | | | 3 | | 3 | |
| | | Irg. 641 | | | | | | | | | | | | 1 | 1 | 1 | | 1 | | 1 |
| Number of replica mold used | | | 1 | 1 | 2 | 3 | 4 | 5 | 6 | 7 | 8 | 9 | 10 | 1 | 1 | 1 | 11 | 11 | 12 | 12 |
| Imprinting conditions | | Transfer pressure (N) | 500 | 500 | 500 | 100 | 100 | 500 | 500 | 500 | 500 | 500 | 500 | 100 | 100 | 100 | 500 | 100 | 500 | 100 |
| | | Transfer time (sec.) | 60 | 60 | 60 | 60 | 60 | 60 | 60 | 60 | 60 | 60 | 60 | 60 | 60 | 60 | 60 | 60 | 60 | 60 |
| | | Irradiance (J) | 1 | 1 | 1 | 1 | 1 | 1 | 1 | 1 | 1 | 1 | 1 | 1 | 1 | 1 | 1 | 1 | 1 | 1 |
| Solvent for residual layer removal | | Acetone | | | | | | | | | | | | Good | Good | | | | Good | Good |
| | | PGMEA | Good | Good | Good | Good | Good | Good | Good | Good | Good | Good | Good | | | | Good | Good | | |
| | | 2.35% TMAH | | | | | | | | | | | | | | Good | | | | |

(continued)

| | | Examples | | | | | | | | | | | | | | Comparative Examples | | | |
|---|---|---|---|---|---|---|---|---|---|---|---|---|---|---|---|---|---|---|---|
| | | 11 | 12 | 13 | 14 | 15 | 16 | 17 | 18 | 19 | 20 | 21 | 22 | 23 | 24 | 3 | 4 | 5 | 6 |
| Evaluations | Mold releasability | Good | Good | Good | Good | Good | Good | Good | Good | Good | Good | Good | Good | Good | Good | Good | Good | Good | Poor |
| | Transfer accuracy | Good | Good | Good | Good | Good | Good | Good | Good | Good | Good | Good | Good | Good | Good | Good | Good | Good | Good |
| | Residual layer removability | Good | Good | Good | Good | Good | Good | Good | Good | Good | Good | Good | Good | Good | Good | Poor | Poor | Poor | Poor |

The abbreviations given in the table indicate as follows:

Curable compound

- CELLOXIDE 2021P: 3,4-Epoxycyclohexylmethyl (3,4-epoxy)cyclohexanecarboxylate, available from Daicel Corporation
- EHPE3150: Adduct of 1,2-epoxy-4-(2-oxiranyl)cyclohexane and 2,2-bis(hydroxymethyl)-1-butanol, available from Daicel Corporation
- OXT-221: 3-Ethyl-3[(3-ethyloxetan-3-yl)methoxy]ethyloxetane, available from Toagosei Co., Ltd.
- PETIA: Pentaerythritol (tri/tetra)acrylate, available from DAICEL-ALLNEX LTD.
- β-CEA: β-Carboxyethyl acrylate, available from DAICEL-ALLNEX LTD.
- EBECRYL 150: Modified bisphenol-A diacrylate, available from DAICEL-ALLNEX LTD.

Photoinitiator

- CPI-110P: Cationic photoinitiator, diphenyl[4-(phenylthiophenyl)sulfonium hexafluorophosphate, available from San-Apro Ltd.
- Irg. 641: Radical photoinitiator, 2,2-dimethoxy-2-phenylacetophenone, available from BASF SE Solvent for residual layer removal
- PGMEA: Propylene glycol methyl ether acetate, available from Daicel Corporation
- TMAH: Tetramethylammonium hydroxide, available from TAMA CHEMICALS CO., LTD.

As a summary of the above description, the configurations according to embodiments of the present invention, as well as variations thereof, will be listed below as appendices.

(1) A resin composition for replica mold formation, the resin composition containing (A) a thermoplastic or thermosetting resin (A) having a transmittance of light at one or more wavelengths from 200 to 450 nm of 50% or more, and (B) a compound capable of absorbing or scattering the light at the wavelength(s), the compound (B) being present in a proportion of 0.5 to 50 parts by weight per 100 parts by weight of the resin (A).
(2) The resin composition according to (1) for replica mold formation, wherein the resin (A) is selected from olefinic resins and silicone resins.
(3) The resin composition according to one of (1) and (2) for replica mold formation, wherein the compound (B) is a compound capable of absorbing light at one or more wavelengths from 200 to 450 nm and is at least one compound selected from benzotriazole compounds, benzophenone compounds, benzoxazinone compounds, cyanoacrylate compounds, benzoxazole compounds, melocyanine compounds, and triazine compounds.
(4) The resin composition according to any one of (1) to (3) for replica mold formation, wherein the compound (B) is at least one compound selected from benzotriazole compounds, benzophenone compounds, benzoxazinone compounds, cyanoacrylate compounds, benzoxazole compounds, melocyanine compounds, and triazine compounds.
(5) The resin composition according to any one of (1) to (4) for replica mold formation, wherein the compound (B) is a compound capable of absorbing light at one or more wavelengths from 200 to 450 nm and is selected from triazine compounds.
(6) The resin composition according to any one of (1) to (5) for replica mold formation, wherein the compound (B) is selected from triazine compounds.
(7) The resin composition according to any one of (1) to (6) for replica mold formation, further containing at least one solvent selected from hydrocarbon solvents, aromatic hydrocarbons solvents, ketones, alcohols, and ethers.
(8) The resin composition according to any one of (1) to (7) for replica mold formation, further containing at least one solvent selected from aromatic hydrocarbons solvents and ketones.
(9) The resin composition according to any one of (1) to (8) for replica mold formation, wherein the resin composition has a viscosity of 1 to 100 mPa·s at 25°C.
(10) A replica mold composed of a cured product or solidified product of the resin composition according to any one of (1) to (9) for replica mold formation.
(11) A replica mold including a cured product or solidified product of the resin composition according to any one of (1) to (9) for replica mold formation.
(12) The replica mold according to (11), which is a multilayer assembly including a substrate and the cured product or solidified product of the resin composition according to any one of (1) to (9) for replica mold formation.
(13) The replica mold according to any one of any one of (10) to (12), wherein the replica mold includes a substrate, and wherein the substrate has a thickness of 50 μm to 5 mm.

(14) The replica mold according to one of (12) and (13), wherein the substrate has a transmittance of light of 90% or more at one or more wavelengths from 200 to 450 nm, provided that the substrate has a thickness of 1 mm.
(15) A method for patterning, the method including: a) pressing the replica mold according to any one of (10) to (14) against a coated film of a photocurable composition, b) curing the coated film, c) removing the replica mold after the step b), and d) removing a residual layer by washing after the step c).
(16) The patterning method according to (15), wherein the photocurable composition contains a curable compound and a photoinitiator, and wherein the curable compound includes a cationically curable compound or a radically curable compound.
(17) The patterning method according to one of (15) and (16), wherein the photocurable composition contains a curable compound and a photoinitiator, and wherein the curable compound includes at least one of an epoxide and an oxetane compound.
(18) The patterning method according to any one of (15) to (17), wherein the photocurable composition contains a curable compound and a photoinitiator, and wherein the curable compound includes a cycloaliphatic epoxide and an oxetane compound.
(19) The patterning method according to any one of (15) to (18), wherein the photocurable composition contains a curable compound and a photoinitiator, and wherein the curable compound includes a compound represented by Formula (i) and a bifunctional oxetane compound.
(20) The patterning method according to any one of (15) to (19), wherein the photocurable composition contains a curable compound and a photoinitiator, and wherein the curable compound includes a bifunctional (meth)acrylate or a trifunctional or higher (meth)acrylate.

Industrial Applicability

Imprinting using the replica mold, which is formed using the resin composition for replica mold formation according to the present invention, enables easy removal of a residual layer typically by washing and can easily and inexpensively produce high-accuracy patterns. In addition, the replica mold enables patterning according to the roll-to-roll process and contributes to dramatically higher working efficiency.

Reference Signs List

1 replica mold
2 photocurable composition
3 substrate
4 cured product of photocurable composition
5 residual layer
6 structure with pattern on substrate

## Claims

**1.** A resin composition for replica mold formation, the resin composition comprising:

(A) a thermoplastic or thermosetting resin having a transmittance of light of 50% or more at one or more wavelengths from 200 to 450 nm; and
(B) a compound capable of absorbing or scattering the light at the wavelength or wavelengths,

the compound (B) being present in a proportion of 0.5 to 50 parts by weight per 100 parts by weight of the resin (A) .

**2.** The resin composition according to claim 1 for replica mold formation,
wherein the resin (A) is selected from olefinic resins and silicone resins.

**3.** A replica mold comprising
a cured product or solidified product of the resin composition according to one of claims 1 and 2 for replica mold formation.

**4.** A method for patterning, the method comprising:

a) pressing the replica mold according to claim 3 against a coated film of a photocurable composition;
b) curing the coated film;
c) removing the replica mold after the step b); and
d) removing a residual layer by washing after the step c) .

[FIG. 1]

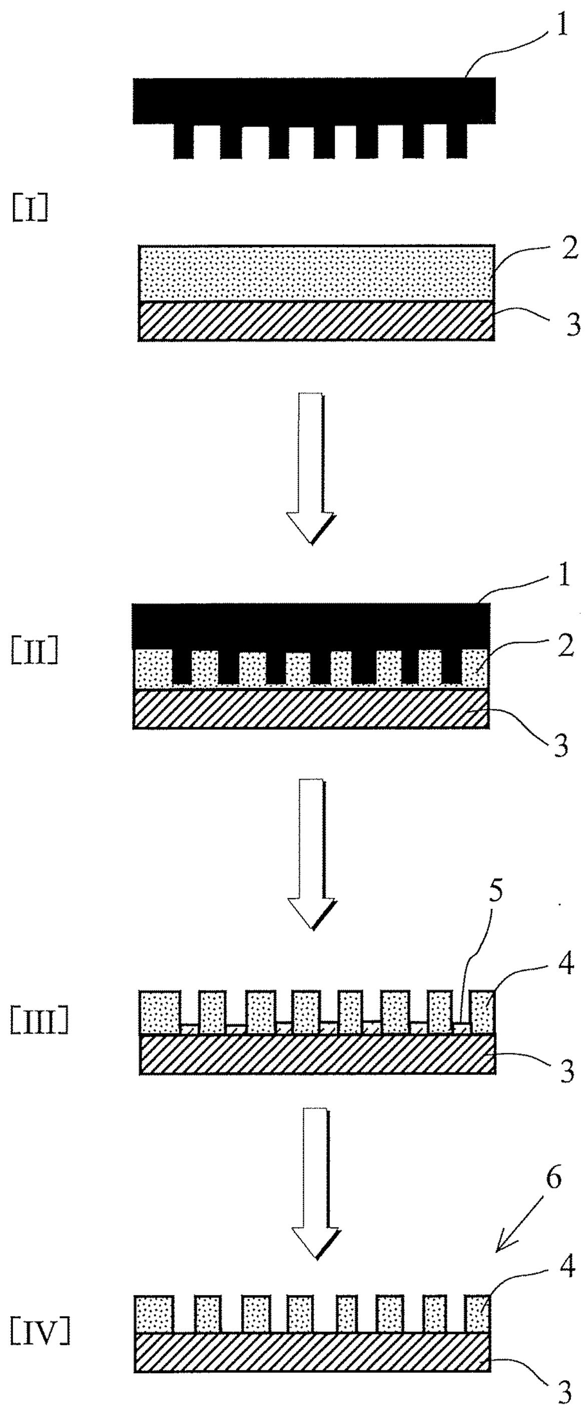

## INTERNATIONAL SEARCH REPORT

International application No.
PCT/JP2017/041288

A. CLASSIFICATION OF SUBJECT MATTER
Int.Cl. C08L101/00(2006.01)i, B29C33/38(2006.01)i, B29C59/02(2006.01)i, C08K3/00(2018.01)i, C08K5/04(2006.01)i, C08K5/16(2006.01)i, C08L23/00(2006.01)i, C08L83/04(2006.01)i, H01L21/027(2006.01)i
According to International Patent Classification (IPC) or to both national classification and IPC

B. FIELDS SEARCHED
Minimum documentation searched (classification system followed by classification symbols)
Int.Cl. C08L1/00-101/16, B29C33/38, B29C59/02, C08K3/00-3/40, C08K5/04-5/357, H01L21/027

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2009-166486 A (ASAHI KASEI CORPORATION) 30 July 2009, claims, paragraphs [0008], [0023]-[0028], [0048]-[0068] (Family: none) | 1, 3-4<br>2 |
| X | WO 2009/093661 A1 (KYOWA HAKKO CHEMICAL CO., LTD.) 30 July 2009, claims, paragraphs [0014]-[0020], [0024]-[0026], [0108], [0113]-[0126], fig. 1 & JP 2011-67950 A | 1-4 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 January 2018 (24.01.2018) | 06 February 2018 (06.02.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2017/041288

C (Continuation). DOCUMENTS CONSIDERED TO BE RELEVANT

| Category* | Citation of document, with indication, where appropriate, of the relevant passages | Relevant to claim No. |
|---|---|---|
| X | WO 2008/132903 A1 (KYOWA HAKKO CHEMICAL CO., LTD.) 06 November 2008, claims, paragraphs [0024]-[0028], [0086]-[0104] & JP 2010-137358 A | 1-4 |
| A | JP 2008-207475 A (RIKEN, JAPAN, NIPPON PAINT CO., LTD.) 11 September 2008 & US 2008/0203271 A1 | 1-4 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016225226 A
- JP 2004304097 A